Europäisches Patentamt

European Patent Office

Office européen des brevets

(19)

(11) Numéro de publication : **0 059 125 B1**

# FASCICULE DE BREVET EUROPÉEN

(12)

(45) Date de publication du fascicule du brevet :
17.05.89

(51) Int. Cl.⁴ : **G 11 C 17/00**

(21) Numéro de dépôt : **82400174.7**

(22) Date de dépôt : **02.02.82**

(54) **Mémoire morte à adressage modifié.**

(30) Priorité : **17.02.81 FR 8103060**

(43) Date de publication de la demande :
**01.09.82 Bulletin 82/35**

(45) Mention de la délivrance du brevet :
**17.05.89 Bulletin 89/20**

(84) Etats contractants désignés :
**DE FR GB NL**

(56) Documents cités :
**DE--A-- 2 327 062**
**US--A-- 3 328 767**
**ELECTRONICS, vol. 43, no.6, 16 mars 1970, New York, US, MARINO et al.:"There's a read-only memory that's sure to fill your needs", pages 112-116**
**EDN, vol 18, no. 22, 20 novembre 1973, Denver, US, GORMAN:" The programmable logic array: a new approach to micro-programing", pages 68-75**
**FIRST USA-JAPAN COMPUTER CONFERENCE PROCEEDINGS, 3 - 5 octobre 1972, Tokyo, JP, MITARAI: "Design of a parallel encoder/decoder for the hamming code using ROM", pages 531-537**

(73) Titulaire : **SGS-THOMSON MICROELECTRONICS S.A.**
**7, Avenue Galliéni**
**F-94250 Gentilly (FR)**

(72) Inventeur : **Brice, Jean-Michel**
**THOMSON-CSF SCPI 173, bld Haussmann**
**F-75360 Paris Cedex 08 (FR)**

(74) Mandataire : **Rinuy, Santarelli**
**14, avenue de la Grande Armée**
**F-75017 Paris (FR)**

EP 0 059 125 B1

Jouve, 18, rue St-Denis, 75001 Paris, France

# EP 0 059 125 B1

**Description**

La présente invention concerne les mémoires mortes programmables agencées en matrices de points mémoires adressables par lignes et/ou par colonnes, et plus particulièrement les mémoires mortes servant à effectuer une microprogrammation au sein d'un circuit intégré.

Ces mémoires font partie du circuit intégré et ont pour fonction de fournir à leurs sorties des mots de chiffres binaires (bits) qui sont des instructions enregistrées à des adresses déterminées désignant le carrefour d'une ligne et d'une colonne de la matrice.

Dans la plus grande généralité des cas, il s'agit de matrices de N points mémoires agencés en L lignes de M mots de P bits chacun. L'un de ces nombres, notamment M ou P, peut d'ailleurs être égal à 1.

Dans toutes les mémoires mortes de microprogrammation existant actuellement, P peut être quelconque, mais on s'arrange pour que L et M soient chacun des nombres multiples de 2 pouvant s'écrire respectivement sous la forme $2^k$ pour L et $2^m$ pour M. On a alors k entrées d'adressage de lignes de la matrice et m entrées d'adressage de colonnes ; n'importe quel nombre à k chiffres binaires appliqué aux entrées d'adressage de lignes désigne alors une ligne et une seule de la matrice, et de même n'importe quel nombre à m chiffres binaires appliqué aux entrées d'adressage de colonnes désigne une colonne et une seule. La combinaison de ces deux adresses désigne un emplacement de mot et un seul dans la mémoire.

$2^k \times 2^m$ de P bits peuvent ainsi être enregistrés dans une matrice à $N = 2^k \times 2^m \times P$ points mémoires, avec k entrées d'adressage de lignes et m entrées d'adressage de colonnes ; P sorties de bits sont prévues pour fournir les mots ou instructions enregistrés au carrefour d'une colonne et d'une ligne désignées par leurs adresses.

Par ailleurs, on a déjà proposé des architectures différentes de simples mémoires mortes programmables, visant à accomplir des opérations logiques sur des mots binaires à l'aide de réseaux de points mémoire ressemblant d'une certaine manière à des mémoires mortes.

Ainsi, les réseaux logiques programmables décrits dans l'article EDN vol. 18 N° 22 du 20 novembre 1976 (Gorman) comprennent deux réseaux programmables pour fournir à la sortie des sommes de produits logiques des adresses d'entrée. Ces réseaux ont un intérêt par rapport à une mémoire morte uniquement lorsque le nombre de produits logiques (donc le nombre de lignes d'entrée du deuxième réseau) est très inférieur à $2^k$ où k est le nombre d'entrées.

Ainsi encore, le brevet allemand 2 327 062 propose une mémoire morte apparemment classique mais comportant des moyens pour additionner ou multiplier à l'intérieur de la mémoire des mots contenus dans cette mémoire. On peut en extraire soit tous les mots stockés soit diverses combinaisons de tous ces mots. Mais cette mémoire comporte classiquement un nombre de lignes qui est une puissance de deux.

L'invention résulte de la remarque inattendue selon laquelle, dans les situations dans lesquelles les relations entre les informations le permettent, on doit pouvoir stocker dans une mémoire à L lignes et M colonnes de mots de P bits un nombre de mots supérieur à $L \times M$, contrairement à ce qui a été expliqué ci-dessus, c'est-à-dire contrairement au cas général où on considère toujours que le nombre de mots stockables dans une mémoire de microprogrammation est égal au nombre d'emplacements de mots dans la mémoire.

En présentant les choses différemment, la présente invention propose de réduire le nombre de points mémoires d'une matrice sans pour autant réduire le nombre de mots de P bits que l'on peut extraire de celle-ci.

Plus précisément, en gardant k entrées d'adressage de lignes et m entrées d'adressage de colonnes (et toujours P bits dans chaque colonne), donc a priori un nombre d'adresses de mots égal à $2^k \times 2^m$, on s'arrange pour réduire le nombre d'emplacements réels de mots, et pour cela on réduit le nombre L de lignes ou le nombre M de colonnes en rendant L inférieur à $2^k$ ou M inférieur à $2^m$ (dans certaines limites que l'on verra dans la suite).

Il en résulte un avantage essentiel qui est la réduction d'encombrement sur le circuit intégré réalisé : la surface de la mémoire est proportionnelle aux nombres de lignes et colonnes de points mémoires et il est particulièrement intéressant de réduire ceux-ci pour une capacité de stockage donnée.

Selon la présente invention on propose de faire un double mode d'adressage de la mémoire en ce sens que pour certaines adresses de lignes et colonnes reçues par les entrées d'adressage de lignes et colonnes, un mot unique sera désigné et émis sur les sorties de la mémoire, ce mot étant au carrefour d'une ligne et d'une colonne déterminées, tandis que pour d'autres adresses, deux mots seront désignés, qui sont aux carrefours de deux lignes et une colonne ou une ligne et deux colonnes, ces mots étant combinés selon une fonction logique simple (ET, OU, NON-ET ou NI) et ainsi émis sur les sorties de la mémoire.

Ceci signifie que la mémoire peut émettre non seulement les mots eux-mêmes qui sont stockés mais par exemple aussi la somme ou le produit de deux mots.

L'intérêt de l'invention est que cette possibilité de stockage de mots en vue de la restitution de plus de mots qu'il n'en a été stocké effectivement, est particulièrement simple à exploiter dans les mémoires intégrées logiques actuelles. En effet, ces mémoires sont agencées de telle manière que le plus souvent il n'y a aucun élément à rajouter au niveau de la mémoire pour obtenir la somme ou le produit de deux mots stockés dans deux lignes ou deux colonnes : il suffit de désigner ces deux lignes ou colonnes au lieu d'une seule et, par construction, la sortie se trouvera être une combinaison logique simple (ET, OU etc...) des deux mots. On explicitera mieux ce point dans la suite. Mais d'ores et déjà on peut dire que la seule modification à apporter à la mémoire se situe au niveau du décodage des adresses d'entrée : il faut pouvoir désigner soit une seule ligne ou colonne (comme d'habitude) soit deux à la fois.

Ainsi, l'invention se définit comme étant une mémoire morte programmable à N points mémoires agencés en L lignes de M mots de P bits chacun (N = L × M × P), avec k entrées d'adressage de lignes et m entrées d'adressage de colonnes, les nombres k et m étant les nombres de bits d'adressage binaire nécessaires à la désignation des L lignes et des M colonnes, L portes de décodage de lignes, M portes de décodage de colonnes et P sorties de bits aptes à transmettre les informations en mémoire dans les P points mémoires au carrefour d'une ligne et d'une colonne de mot désignées respectivement par une porte de décodage de lignes et une porte de décodage de colonnes selon les niveaux logiques appliqués aux entrées d'adressage, caractérisée en ce que L et/ou respectivement M est strictement compris entre $2^{k-1}$ et $2^k$ (respectivement $2^{m-1}$ et $2^m$) et en ce qu'un décodeur supplémentaire est prévu entre les entrées d'adressage de lignes et/ou respectivement de colonnes et les entrées des portes de décodage de lignes (respectivement de colonnes), ce décodeur étant apte à transmettre aux entrées des portes de décodage de lignes (respectivement de colonnes) des niveaux logiques correspondant :

— à la désignation d'une seule ligne (respectivement colonne) correspondante pour chacune de L (respectivement M) adresses données parmi les $2^k$ (respectivement $2^m$) adresses susceptibles d'être reçues par le décodeur supplémentaire ;

— à la désignation de deux lignes (respectivement colonnes) correspondantes pour chacune des $2^k$-L (respectivement $2^M$-M) adresses restantes susceptibles d'être reçues par le décodeur supplémentaire, qui correspondent à des lignes (respectivement colonnes) fictives, les mots appliqués aux sorties de la mémoire étant dans ce cas la somme ou le produit logique des mots stockés aux carrefours de chaque colonne (respectivement ligne) désignée et de chaque ligne (respectivement colonne) désignée.

On expliquera dans la suite comment, pour certaines adresses reçues par le décodeur supplémentaire, celui-ci transmet, directement et sans modification, aux entrées communes des portes de décodage de lignes (resp. colonnes), les niveaux logiques et les compléments des chiffres binaires constituant les adresses reçues, et comment, pour d'autres adresses, le décodeur supplémentaire transmet les niveaux logiques et les compléments des chiffres binaires constituant les adresses, mais avec une modification telle que deux portes de décodage de lignes (resp. colonnes) reçoivent simultanément des niveaux logiques d'entrée qui leur font désigner simultanément deux lignes (resp. colonnes).

Cette modification effectuée par le décodeur supplémentaire pour ces autres adresses consiste en fait à appliquer sur deux entrées communes des portes de décodage de lignes (resp. colonnes), qui devraient normalement recevoir un niveau logique et son complément, deux niveaux logiques identiques.

On peut prévoir que les entrées d'adressage de lignes, ou respectivement les entrées d'adressage de colonnes, comprennent une entrée spécifique destinée au décodeur supplémentaire, le niveau logique présent sur cette entrée ayant pour fonction de définir si le décodeur supplémentaire doit autoriser la désignation d'une seule ligne (resp. colonne), laquelle est alors définie par les niveaux logiques présents sur les autres entrées d'adressage, ou s'il doit autoriser la désignation de deux lignes (resp. colonnes) ; ces deux lignes (resp. colonnes) sont également définies par les autres entrées d'adressage et sont alors de préférence d'une part la ligne (resp. colonne) qui correspondrait normalement à l'adresse indiquée par ces autres entrées si le décodeur supplémentaire ne désignait qu'une ligne, et d'autre part une ligne correspondant à une adresse différant de la précédente par une chiffre binaire et un seul.

Pour que deux portes de décodage de lignes (resp. de colonnes) désignent simultanément ces deux adresses, on prévoit qu'un inverseur commandé est inséré en amont d'une des entrées communes des portes de décodage de lignes (resp. de colonnes). Les autres entrées reçoivent les niveaux logiques correspondant aux chiffres binaires des adresses désignées et à leurs compléments. L'inverseur est commandé par l'entrée spécifique prévue parmi les entrées d'adressage.

Dans une autre réalisation, on évite cette entrée spécifique de modification d'adressage. Les k (resp. m) entrées servent pour la définition des adresses. Le décodeur supplémentaire comporte 2k (resp. 2m) sorties. Pour certaines adresses introduites sur les entrées d'adressage, donc sur le décodeur supplémentaire, celui-ci délivre sur ses sorties les k (resp. m) niveaux d'entrée et leurs compléments (soit 2k sorties ou respectivement 2m) ; ces k niveaux et leurs compléments désignent une ligne et une seule (resp. une colonne et une seule). Pour d'autres adresses, le décodeur délivre k — 1 (resp. m — 1) entrées et leurs k — 1 (resp. m — 1) compléments et deux niveaux logiques identiques sur les deux sorties restantes du décodeur. Ceci implique la désignation de deux lignes ou deux colonnes de la mémoire étant donné la constitution des portes de décodage de lignes (resp. colonnes) qui sont des portes simples (ET, OU, NOR ou NAND).

On montrera comment on peut faire en sorte que le décodeur supplémentaire effectue ce choix entre un adressage normal et un adressage double selon les adresses d'entrée qu'il reçoit. On peut déjà signaler que cela est possible en prévoyant que le décodeur supplémentaire, à k entrées et 2k sorties (resp. m et 2m), transmet sur la plupart de ses sorties le niveau logique d'une entrée correspondante et son complément comme on le fait déjà dans les mémoires classiques, à l'exception de trois sorties qui combinent des entrées d'une manière particulière pour fournir des signaux composites.

Dans le premier mode de réalisation de l'invention, où une entrée spécifique d'adressage permet de choisir le mode d'adressage (normal ou modifié) des lignes ou colonnes, l'utilisateur doit tenir compte, dans les adresses qu'il transmet à la mémoire, de la manière dont celle-ci est constituée.

Dans le second mode de réalisation, l'utilisateur voit les entrées d'adressage de la mémoire exactement comme s'il s'agissait d'une mémoire classique. Il n'a pas à se préoccuper de constituer des adresses particulières car c'est le décodeur supplémentaire qui, quoiqu'il soit constitué de manière extrêmement simple (à la limite, deux portes à deux entrées seulement en plus des inverseurs toujours nécessaires), se débrouille pour reconnaître qu'un certain nombre d'adresses d'entrées nécessitent une désignation de deux lignes ou colonnes simultanément et pour procéder à cette désignation simultanée des lignes convenables.

D'autres caractéristiques et avantages de l'invention apparaîtront à la lecture de la description détaillée qui suit et qui est faite en référence aux dessins annexés dans lesquels :

la figure 1  représente un diagramme schématique montrant l'agencement général d'une mémoire matricielle ;

la figure 2  représente un exemple de réalisation pratique d'une mémoire dans laquelle les points mémoires sont constitués par la connexion ou l'absence de connexion d'un transistor entre une ligne et une colonne ;

la figure 3  représente une réalisation classique de portes de décodage de lignes ou de colonnes ;

la figure 4  représente une structure de mémoire modifiée selon la présente invention ;

la figure 5  représente une réalisation du décodeur supplémentaire avec une entrée spécifique pour l'adressage modifié ;

la figure 6  représente une variante de réalisation du décodeur supplémentaire ne nécessitant pas une entrée spécifique de modification d'adressage ;

la figure 7  représente un autre exemple de réalisation sans entrée spécifique de modification d'adressage.

On peut faire comprendre l'invention de manière simple en montrant d'abord que deux mots de P bits peuvent être combinés très simplement pour en donner un troisième.

Exemple : si on applique la fonction ET (produit logique) aux mots 0001 et 0010, on obtient 0000 ; de même, 0101 et 0110 donnent 0100 ; à partir de quatre mots on en obtient donc six si on les prend soit simplement, soit en en multipliant deux.

Ainsi, si on stocke dans une matrice de points mémoires les nombres suivants :

```
0001    0101    1001    1101
0010    0110    1010    1110
0011    0111    1011    1111
```

on peut facilement reconstituer, par une simple fonction ET regroupant certains nombres deux à deux, les nombres 0000, 1100, 0100, 1000, de sorte qu'au total, ayant stocké les douze nombres précédents et reconstituant les quatre autres, on dispose de la totalité des seize nombres de quatre chiffres existant.

Il faut tout de suite mentionner ici que l'on aurait pu réaliser la même chose par des fonctions OU, NAND ou NOR. En effet la fonction OU sur 0001 et 0010 donne 0011 que l'on peut donc faire disparaître de la table. La fonction NAND appliquée à 0001 et 0010 donne 1111 que l'on peut faire disparaître. La fonction NOR appliquée à 0001 et 0010 donne 1100 que l'on peut faire disparaître.

Quelle que soit la fonction choisie, on peut voir que sur quatre mots on peut en supprimer un (indépendamment du nombre de bits du mot).

Ceci montre que l'on peut réaliser, au moins dans cet exemple simple, une mémoire qui n'aurait que douze emplacements de mots, mais dont on pourrait extraire 16 mots en utilisant soit un mot stocké soit deux mots stockés combinés grâce à l'une des quatre fonctions logiques simples.

La condition pour le faire est que l'on puisse accéder dans la mémoire à deux positions de mots simultanément et combiner ces deux mots selon la fonction choisie.

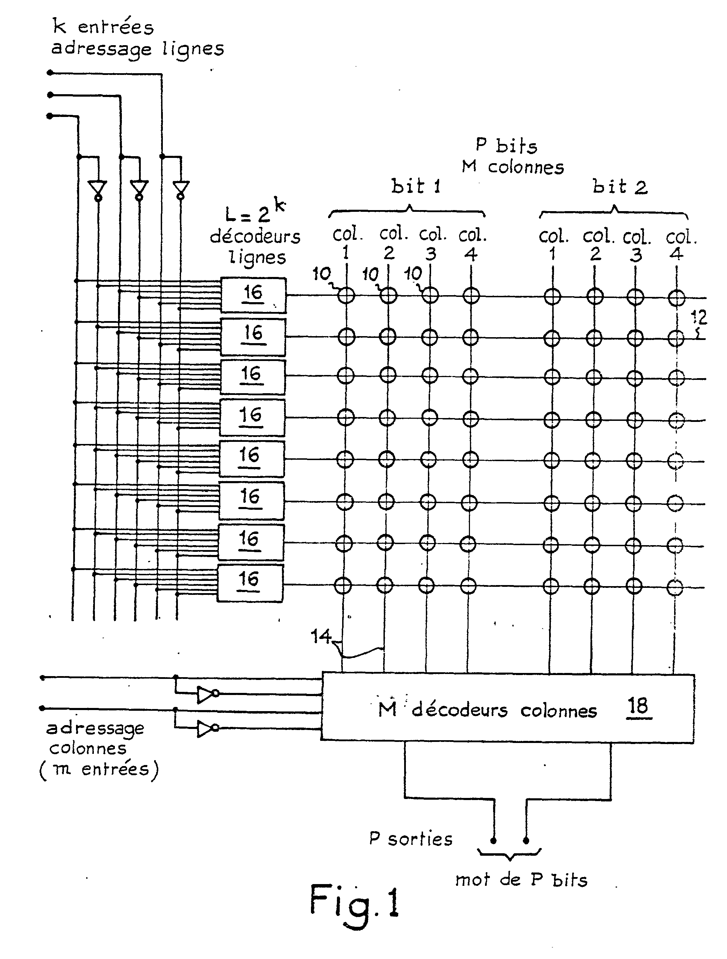

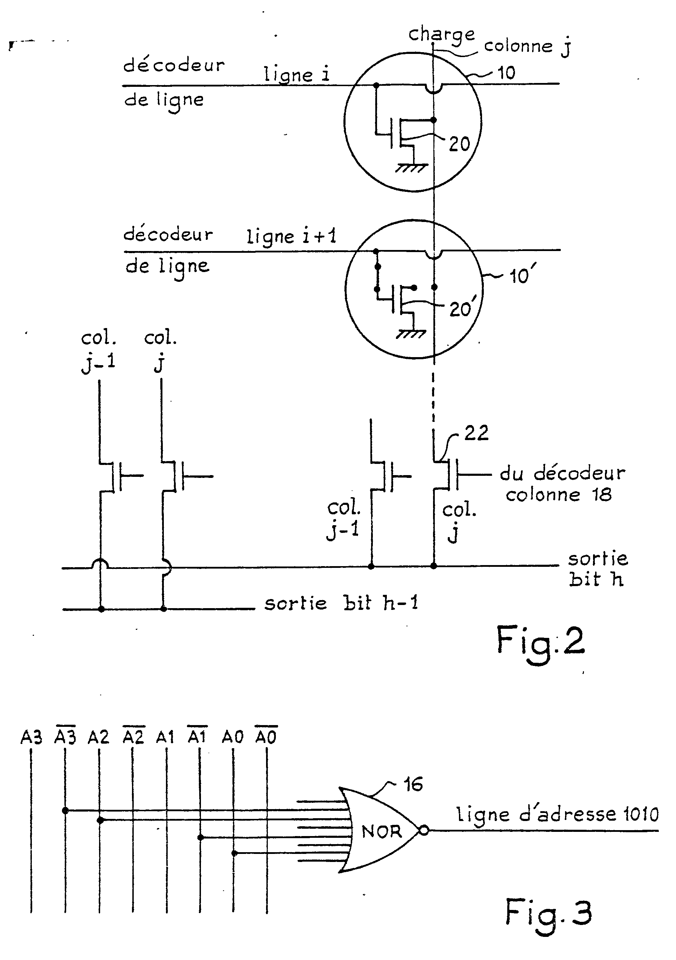

On va maintenant décrire en relation avec les figures 1 et 2 une constitution classique de matrice de points mémoires, pour montrer comment on peut facilement réaliser la condition ci-dessus.

La matrice de la figure 1 comprend un certain nombre de points mémoires figurés par des cercles 10, chacun au carrefour d'un conducteur de ligne 12 et d'un conducteur de colonne 14.

Les points mémoires définissent chacun un état binaire 0 ou 1 et ils sont agencés, sur chaque ligne, en mots de un ou plusieurs bits. Dans le cas général, on peut avoir L lignes de M mots de P bits chacun, mais dans certains cas on peut avoir L lignes de M mots de 1 bit ou L lignes avec sur chacune un seul mot de P bits.

La sortie de la mémoire est constituée de P sorties individuelles pour permettre l'extraction d'un mot de P bits.

Dans la suite on appellera généralement colonne, une colonne de mots, et exceptionnellement on pourra parler d'un conducteur de colonne de bit lorsque cela sera nécessaire.

Des entrées d'adressage de lignes en nombre k permettent de définir $2^k$ adresses possibles selon les niveaux logiques qui leur sont appliqués. Ces niveaux, et leurs compléments, sont donc dirigés sur des entrées communes d'adressage de L portes de décodage de lignes 16, chacune étant agencée pour répondre à la présence d'une adresse bien déterminée sur ses entrées et pour désigner alors une ligne de mots bien déterminée. Toutes les mémoires usuelles possèdent $2^k$ lignes et $2^k$ portes de décodage de lignes 16 si elles ont k entrées d'adressage de lignes.

Des entrées d'adressage de colonnes (de mots) sont également prévues (si M est différent de 1), en nombre m (M = $2^m$ pour toutes les mémoires usuelles). Ces entrées servent à appliquer des niveaux logiques correspondant à des adresses de colonnes, et leurs compléments, à des entrées communes de portes de décodage de colonnes (de mots) 18 qui ont pour fonction de désigner chacune une colonne déterminée afin de transmettre aux sorties de la mémoire un mot de P bits présent dans cette colonne au niveau d'une ligne déterminée. Les portes de décodage de colonnes sont des décodeurs 1 parmi M et elles sont en nombre M. Chaque porte de décodage 18 sélectionne une colonne de mots donc P conducteurs de colonne de bits. On remarquera d'ailleurs que les conducteurs de colonnes de bits d'une même colonne de mot peuvent être adjacents, ou alors, comme à la figure 1, on peut avoir les colonnes de mots intercalées les unes dans les autres de sorte qu'une colonne de mot comprend en fait plusieurs conducteurs non adjacents.

La figure 2 montre un exemple de réalisation classique dans lequel chaque point mémoire 10 comprend un transistor MOS 20 dont la grille de commande est reliée à un conducteur de ligne et dont la source et le drain sont reliés l'un à la masse, l'autre à un conducteur de colonne relié lui-même, à travers une charge résistive, à un potentiel positif.

L'état du point mémoire est défini par la présence ou l'absence de ce transistor 20 entre un conducteur de ligne et un conducteur de colonne. En 10' on a représenté un autre point mémoire dont le transistor 20' est isolé de la colonne correspondante et ne joue donc aucun rôle.

On dira ici que la présence d'un transistor définit un état logique 0 pour le point mémoire, tandis que son absence ou sa déconnexion définit un état 1.

Si on applique sur le conducteur de ligne i un potentiel positif, le transistor 20 conduit et met à la masse (dans le cas de la figure 1), la colonne j. Si cette colonne est sélectionnée par la porte de décodage de colonnes à laquelle elle est reliée, un niveau 0 sera transmis sur une sortie de la mémoire. La sélection de colonne se fait par un transistor-interrupteur 22 commandé par la porte de décodage de colonne 18.

Cette structure est très classique et peut se retrouver avec de nombreuses variantes.

Il est facile de voir que si deux conducteurs de lignes transmettent simultanément un potentiel positif (alors que dans les mémoires classiques une seule ligne est désignée), le niveau logique qui se retrouvera en sortie est le produit logique des états logiques des points mémoires sur ces deux lignes, c'est-à-dire le produit des niveaux qu'on retrouverait sur la sortie si les lignes étaient désignées séparément.

En effet, c'est la mise à la masse d'une colonne qui transmet prioritairement un zéro sur la sortie, de sorte que l'on peut dire que si au moins un transistor 20 est présent et est rendu conducteur, la colonne correspondante sera mise à la masse. C'est seulement si tous les transistors sont absents ou rendus non conducteurs que l'on retrouve un 1 sur la colonne. Il s'agit donc d'une fonction ET directement réalisée par la simple désignation de deux lignes simultanément. Le produit logique de deux mots d'une colonne se retrouve en sortie de la mémoire.

On montrerait de la même manière que la configuration de la figure 2 fait que la désignation de deux colonnes simultanément produit en sortie une fonction ET sur les mots stockés dans ces deux colonnes au niveau d'une ligne déterminée. On peut d'ailleurs aussi indiquer à cet endroit que la désignation de deux lignes et de deux colonnes simultanément produirait le produit logique des quatre mots en mémoire aux carrefours de ces deux lignes et deux colonnes.

L'exemple pratique de la figure 2 fait ressortir la réalisation diurecte de fonctions ET. Si on le modifie légèrement, par exemple en prévoyant que le transistor 20 est relié d'une part à un potentiel positif et d'autre part à la colonne qui elle-même serait reliée à la masse par l'intermédiaire d'une charge résistive, on réalise une fonction OU (somme logique) avec deux lignes ou deux colonnes commandées simultanément.

De même, encore, d'autres montages simples constitueraient des mémoires dont les sorties pourraient donner des fonctions NAND ou NOR de deux mots stockés dans deux lignes ou deux colonnes désignées simultanément.

A la figure 3, on a représenté une porte de décodage de lignes 16 (ou de colonnes 18), tel qu'il existe dans une mémoire classique. Il s'agit d'une simple porte ET, OU, NAND ou NOR, ici une porte NOR qui reçoit sur ses entrées des signaux issus des entrées d'adressage de la mémoire. Cette porte délivre un signal logique 0, sauf si une combinaison d'entrées bien précise est reçue sur ses entrées. C'est pourquoi, bien qu'on ait représenté à la figure 1 2k entrées communes pour toutes les portes de décodage de lignes 16, en fait, les portes de décodage sont chacune connectée effectivement à k conducteurs et c'est le choix des k connexions qui détermine l'adresse à la présence de laquelle réagira.une porte de décodage.

Ainsi, si les entrées d'adressage sont par exemple A3, A2, A1, A0, et les entrées communes des portes de décodage de lignes sont A3, $\overline{A3}$, A2, $\overline{A2}$, A1, $\overline{A1}$, A0, $\overline{A0}$, et si on veut qu'une porte de décodage réagisse à la présence de l'adresse 1010, on connectera les entrées de la porte NOR aux conducteurs d'entrées communes $\overline{A3}$, A2, $\overline{A1}$, A0.

Une autre porte de décodage devant réagir à l'adresse 1011 sera connectée aux conducteurs $\overline{A3}$, A2, $\overline{A1}$, $\overline{A0}$.

Cette explication était nécessaire pour faire comprendre ensuite que si on s'arrange artificiellement pour mettre un 0 logique à la fois sur le conducteur A0 et sur le conducteur $\overline{A0}$ alors qu'ils devraient transmettre des niveaux complémentaires, les deux portes de décodage ci-dessus réagiront.

On parlera dans toute la suite de portes de décodage 16 (ou 18 pour les colonnes) à 2k (ou 2m) entrées, en sachant bien que dans la pratique la manière la plus simple de les réaliser est d'utiliser des portes à k (ou m) entrées connectées à certains des 2k (ou 2m) conducteurs communs issus des entrées d'adressage.

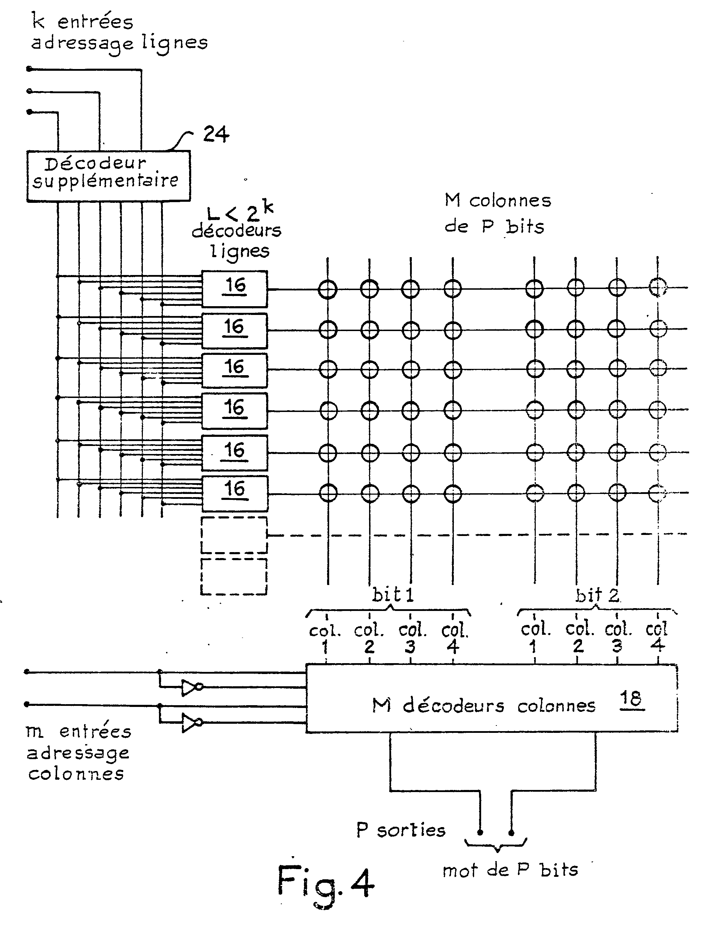

A la figure 4 est représenté le schéma de la mémoire selon l'invention. Elle diffère de la figure 1 sur les points suivants :

— plusieurs lignes de points mémoires ont été supprimées, ainsi que les portes de décodage de lignes 16 correspondantes, de sorte que le nombre de lignes restantes L est strictement inférieur à $2^k$ si k est le nombre d'entrées d'adressage ;

— un décodeur supplémentaire 24 a été inséré entre les entrées d'adressage de lignes et les entrées communes des portes de décodage 16, de sorte que ce ne sont plus simplement les niveaux logiques sur les entrées d'adressage et leurs compléments qui sont transmis aux portes de décodage de lignes.

Il faut noter que les portes de décodage de lignes 16 restant sont inchangées, ainsi que les portes de décodage de colonnes. D'autre part, le décodeur supplémentaire 24 est très simple et ne produit qu'un encombrement réduit (inférieur à une seule des portes de décodage 16 qui ont été supprimées), de sorte que le gain global de place est important.

Il faut noter encore que la modification d'adressage de lignes qui est représentée à la figure 3 et qui va être décrite en détail pourrait être une modification d'adressage de colonnes, auquel cas le décodeur supplémentaire 24 serait inséré entre les entrées d'adressage de colonnes et les entrées des portes de décodage de colonnes, et un certain nombre de colonnes (au lieu de lignes) seraient supprimées avec les portes de décodage de colonnes correspondantes. On peut également envisager dans certains cas de prévoir à la fois une suppression de lignes et une suppression de colonnes, avec un décodeur supplémentaire pour les lignes et un décodeur supplémentaire pour les colonnes.

On décrira la suite en supposant qu'il s'agit du cas de la figure 4 (lignes), la transposition étant immédiate pour les colonnes.

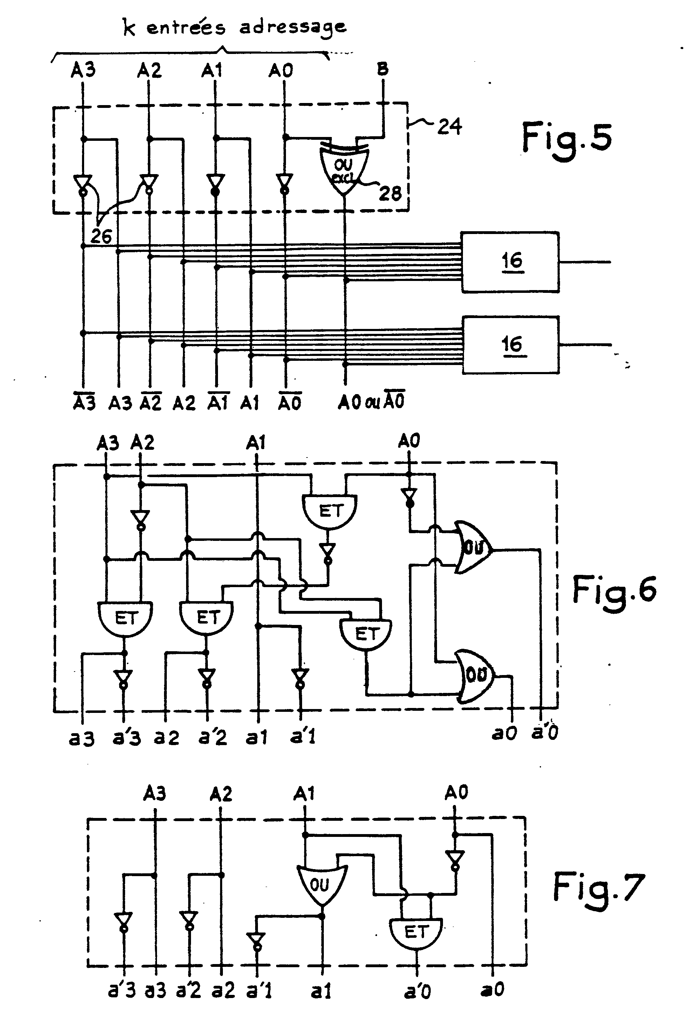

Deux grandes variantes de réalisation du décodeur supplémentaire peuvent être envisagées. Elles sont représentées à la figure 5 d'une part, aux figures 6 et 7 d'autre part ; toutes deux permettent de transmettre aux entrées des portes de décodage de ligne 16 conservées des niveaux logiques correspondant

soit à la désignation d'une seule ligne pour certaines adresses reçues par le décodeur supplémentaire ;

soit à la désignation de deux lignes pour d'autres adresses.

La réalisation de la figure 5 a l'avantage d'être extrêmement simple et donc peu encombrante sur le circuit intégré, mais elle a l'inconvénient de nécessiter une entrée d'adressage supplémentaire, affectée spécialement à une fonction bien particulière qui consiste à indiquer si le décodeur doit désigner une seule ligne ou s'il doit en désigner deux. Les k entrées normales servent à définir ces lignes.

Le décodeur supplémentaire 24 comprend essentiellement des inverseurs (26) qui d'ailleurs étaient déjà nécessaires dans les mémoires classiques. Mais, en plus, un inverseur commandé 28 permet d'inverser à volonté le niveau présent sur l'une des k entrées d'adressage normales. C'est l'entrée spécifique qui commande cet inverseur 28, lequel est constitué par exemple par une porte OU-exclusif recevant sur une entrée le signal à inverser, provenant directement d'une des k entrées d'adressage, et sur une autre entrée le signal issu de l'entrée spécifique.

Sur la figure 5, on a représenté un adressage par cinq entrées A0, A1, A2, A3 et B, l'entrée B étant l'entrée spécifique.

Le décodeur possède 2k sorties pour fournir d'une part les niveaux présents sur les k entrées et d'autre part leurs k compléments, à l'exception de l'un de ces niveaux, qui, lui, est inversé ou non par l'inverseur commandé 28. En effet, si le niveau logique sur l'entrée spécifique B est 0, on a bien sur la dernière sortie le niveau logique de l'entrée A0, mais si le niveau sur B est 1, on retrouve $\overline{A0}$ sur les deux dernières sorties au lieu d'avoir A0 et son complément comme dans les mémoires classiques.

Ceci permet que deux portes de décodage de lignes 16 réagissent simultanément (dans le cas ou B = 1) à la présence d'une adresse déterminée définie alors par A1, A2 et A3 : par exemple, si l'adresse A3, A2, A1, A0 est 1011 et si B = 1, les portes de décodage réagissant aux adresses 1011 et 1010 commanderont les deux lignes correspondantes ; si B = 0, seule l'adresse 1011 sera prise en compte.

Il faut remarquer que si B = 1, il faudra prévoir un état bien déterminé pour A0 (état 0 si les portes de décodage de lignes 16 sont des portes NOR, 1 si ce sont des portes ET), pour éviter que ni l'une ni l'autre des portes de décodage ne réagissent. Ceci interdit d'utiliser certaines adresses à k + 1 chiffres, ce qui est d'ailleurs normal puisqu'on ne cherche pas à extraire plus de $2^k$ mots de la mémoire.

D'autres adresses sont interdites du fait que même si B = 0 (une seule désignation de ligne), on ne peut pas désigner des lignes qui ont été supprimées par rapport à la matrice complète de la figure 1.

L'avantage de la simplicité du décodeur 24 est donc tempéré par deux inconvénients : la nécessité d'un bit supplémentaire dans l'adresse par rapport à ce qui serait nécessaire compte tenu du nombre de mots à extraire de la mémoire ; et l'obligation d'éviter d'utiliser des adresses interdites. On verra que les réalisations des figures 6 et 7 évitent ces deux inconvénients, moyennant un décodeur un peu plus compliqué.

Pour terminer la description de la figure 5, on peut préciser que n'importe laquelle des k entrées d'adressage proprement dites peut être choisie pour être commandée par l'entrée spécifique ; on a choisi A0 sur la figure 5. Bien entendu, l'utilisateur doit tenir compte de ce qui a été choisi pour savoir quelles sont les lignes qui seront combinées pour donner des mots non effectivement stockés dans la mémoire.

Avant de décrire la réalisation de la figure 6, on va montrer sur un exemple simple que l'on peut facilement trouver des combinaisons logiques très simples permettant de faire en sorte que :

— pour certaines adresses à k chiffres on transmette directement ces adresses à des portes de décodage de lignes 16 effectivement présentes dans la matrice,

— pour d'autres adresses à k chiffres, correspondant normalement à des portes de décodage de lignes supprimées et à des lignes supprimées, on transforme chacune de ces autres adresses en deux adresses de lignes existant réellement, pour commander simultanément ces deux lignes.

Soit par exemple le tableau des adresses possibles pour accéder à $2^4$ lignes (adresses à 4 chiffres A0, A1, A2, A3). Dans une mémoire normale, chacune des adresses ci-dessous donne accès à une ligne parmi 16.

| | A3 | A2 | A1 | A0 | | | A3 | A2 | A1 | A0 |
|---|---|---|---|---|---|---|---|---|---|---|
| ligne 1 : | 0 | 0 | 0 | 0 | | ligne 9 : | 1 | 0 | 0 | 0 |
| ligne 2 : | 0 | 0 | 0 | 1 | | ligne 10 : | 1 | 0 | 0 | 1 |
| ligne 3 : | 0 | 0 | 1 | 0 | | ligne 11 : | 1 | 0 | 1 | 0 |
| ligne 4 : | 0 | 0 | 1 | 1 | | ligne 12 : | 1 | 0 | 1 | 1 |
| ligne 5 : | 0 | 1 | 0 | 0 | | ligne 13 : | 1 | 1 | 0 | 0 |
| ligne 6 : | 0 | 1 | 0 | 1 | | ligne 14 : | 1 | 1 | 0 | 1 |
| ligne 7 : | 0 | 1 | 1 | 0 | | ligne 15 : | 1 | 1 | 1 | 0 |
| ligne 8 : | 0 | 1 | 1 | 1 | | ligne 16 : | 1 | 1 | 1 | 1 |

On suppose qu'on veut supprimer quatre lignes pour économiser 25 % de place et que l'on s'arrangera lors de la programmation de la matrice, pour réaliser un certain nombre de mots par combinaison de mots présents dans la même colonne sur deux lignes distinctes.

On peut par exemple supprimer les quatre dernières lignes et prévoir que les adresses de ces quatre lignes seront transformées en adresses de deux lignes à la fois, les douze premières adresses servant toujours à désigner les douze premières lignes.

Si dans ces conditions on prévoit que la treizième adresse servira à désigner les cinquième et sixième lignes à la fois, la quatorzième à désigner les première et seconde lignes, la quinzième à désigner les septième et huitième lignes, et la seizième les troisième et quatrième lignes, on aboutit au tableau d'adresses suivant :

| A3 | A2 | A1 | A0 | | | A3 | A2 | A1 | A0 | |
|---|---|---|---|---|---|---|---|---|---|---|
| 0 | 0 | 0 | 0 | ligne 1; | | 1 | 0 | 0 | 0 | ligne 9; |
| 0 | 0 | 0 | 1 | ligne 2; | | 1 | 0 | 0 | 1 | ligne 10; |
| 0 | 0 | 1 | 0 | ligne 3; | | 1 | 0 | 1 | 0 | ligne 11; |
| 0 | 0 | 1 | 1 | ligne 4; | | 1 | 0 | 1 | 1 | ligne 12; |
| 0 | 1 | 0 | 0 | ligne 5; | | 1 | 1 | 0 | 0 | lignes 5 et 6; |
| 0 | 1 | 0 | 1 | ligne 6; | | 1 | 1 | 0 | 1 | lignes 1 et 2; |
| 0 | 1 | 1 | 0 | ligne 7; | | 1 | 1 | 1 | 0 | lignes 7 et 8; |
| 0 | 1 | 1 | 1 | ligne 8; | | 1 | 1 | 1 | 1 | lignes 3 et 4. |

Il faut donc que les huit entrées communes prévues pour les décodeurs de lignes, entrées que l'on peut appeler a3, a'3, a2, a'2, a1, a'1, a0, a'0, reçoivent tout simplement respectivement A3, $\overline{A3}$, A2, $\overline{A2}$, A1, $\overline{A1}$, A0, $\overline{A0}$ lorsque les douze premières adresses sont appliquées, mais des combinaisons plus complexes pour les quatre dernières.

En faisant les tables de vérité et calculs logiques nécessaires, on aboutit à trouver que la solution est d'appliquer aux entrées des décodeurs de lignes (donc aux sorties du décodeur supplémentaire) les combinaisons logiques suivantes :

$$a3 = A3 \cdot \overline{A2} \; ; \qquad\qquad\qquad\qquad\qquad\qquad a'3 = \overline{a3}$$
$$a2 = A2 \cdot \overline{A3 \cdot A0} \qquad\qquad\qquad\qquad\qquad\qquad a'2 = \overline{a2}$$
$$a1 = A1 \qquad\qquad\qquad\qquad\qquad\qquad\qquad\qquad a'1 = \overline{a1}$$
$$a0 = A0 + A3 \cdot A2 \qquad\qquad\qquad a'0 = \overline{A0} + A3 \cdot A2$$

(dans le cas où les décodeurs 16 sont des portes NOR).

Le décodeur peut être réalisé par conséquent avec très peu de portes logiques en plus des inverseurs qu'il faut de toute façon prévoir en aval des entrées d'adressage d'une mémoire normale. Une douzaine de transistors doivent être rajoutés, ce qui est un très petit nombre compte tenu de l'encombrement économisé. Ce décodeur est représenté à la figure 6.

Le décodeur n'est pas rendu plus complexe lorsqu'augmente le nombre d'entrées d'adressage pourvu qu'on fasse attention à choisir les lignes que l'on supprime et celles que l'on combine deux à deux.

Il est d'ailleurs possible de choisir les lignes à supprimer et celles à combiner de manière à réaliser un décodeur supplémentaire plus simple encore.

En effet, si l'on réécrit le tableau des 16 adresses en supprimant non pas les quatre dernières lignes mais une ligne sur quatre, par exemple la première, la cinquième, la neuvième etc., quel que soit d'ailleurs le nombre de lignes, il reste les adresses suivantes qui désignent les lignes restantes numérotées de 1 à ¨12 dans le tableau ci-dessous :

Les adresses des lignes supprimées servent maintenant à désigner les groupes de lignes suivants :

| adresses | | | |
|---|---|---|---|
| ...0000 | : | lignes | 2 et 3 |
| ...0100 | : | lignes | 5 et 6 |
| ...1000 | : | lignes | 8 et 9 |
| ...1100 | : | lignes | 11 et 12 |
| | | etc., s'il y en a plus. | |

Dans ces conditions, une table de vérité adéquate montre rapidement que l'on peut faire un décodeur 24 dans lequel les 2k sorties a0, a'0, a1, a'1..., au lieu d'être respectivement égales aux k entrées A0, A1... et à leurs k compléments $\overline{A0}$, $\overline{A1}$ (cas d'une mémoire classique), comprennent tout simplement :

1) k-2 sorties a2, a3... qui sont égales aux k-2 entrées correspondantes ;

2) k-2 sorties a'2, a'3... qui sont les compléments des précédentes, comme dans une mémoire classique ;

3) quatre autres sorties qui sont a0, a'0, a1, a'1 et qui fournissent les combinaisons suivantes

$$a0 = A0$$
$$a'0 = \overline{A0} \cdot A1$$
$$a1 = A1 + \overline{A0}$$
$$a'1 = \overline{a1}$$

Le décodeur 24 qui en résulte ne comporte donc, en plus des inverseurs déjà nécessaires dans une mémoire classique, qu'une porte OU pour faire a1, et une porte ET pour faire a'0.

Ce décodeur est représenté à la figure 7.

Par rapport au décodeur de la figure 6 il présente l'avantage d'être plus simple, mais il souffre d'un inconvénient pour l'utilisateur du fait que les adresses binaires prises dans leur ordre classique ne correspondront pas aux numéros des lignes effectivement présentes dans la matrice : par exemple, l'adresse binaire 1010 ne répondra pas à une ligne numéro 10 mais à une ligne numéro 8.

Par rapport au décodeur encore plus simple de la figure 5, les décodeurs des figures 6 et 7 présentent l'avantage de ne pas nécessiter de bit d'adressage spécifique supplémentaire (pour une même capacité), et de ne pas présenter, pour l'utilisateur, d'adresses interdites.

On arriverait à des combinaisons logiques légèrement différentes mais aussi simples si on avait choisi de supprimer par exemple les quatrième, huitième, douzième lignes etc., au lieu des première, cinquième etc., ou si les décodeurs de lignes étaient faits de portes ET au lieu de NOR. On ne peut évidemment décrire toutes les solutions possibles, mais on a donné les éléments d'explication suffisants pour réaliser le décodeur supplémentaire de manière simple.

On peut noter que dans certains cas, il peut être souhaitable de prévoir un décodeur supplémentaire à la fois pour les lignes et pour les colonnes dans une matrice où on aurait supprimé à la fois des lignes et des colonnes ; dans ce cas, on peut gagner encore de l'espace en réduisant le nombre de mots effectivement stockés. On peut alors désigner une ligne et une colonne, ou deux lignes et une colonne, ou une ligne et deux colonnes, ou même dans certains cas deux lignes et deux colonnes, (dans ce dernier cas, le mot de sortie est la combinaison, somme ou produit, de quatre mots effectivement stockés).

L'invention s'applique dans toute situation dans laquelle les relations entre les informations le permettent. Une condition pour la simplicité de mise en œuvre est cependant que la lecture de deux lignes ou colonnes soit directement possible sans destruction des informations stockées sans qu'il soit nécessaire de rajouter des tampons d'isolation entre lignes.

**Revendications**

1. Mémoire morte programmable à N points mémoires (10) agencés en L lignes (12) de M mots de P bits chacun ($N = L \times M \times P$), avec k entrées d'adressage de lignes, et m entrées d'adressage de colonnes, les nombres k et m étant les nombres de bits d'adressage binaire nécessaires à la désignation des L lignes et des M colonnes, L portes de décodage de ligne (16), M portes de décodage de colonne (18) et P sorties de bits aptes à transmettre les informations en mémoire dans les P points mémoires au carrefour d'une ligne et d'une colonne de mot désignées respectivement par une porte de décodage de lignes et une porte de décodage de colonnes selon les niveaux logiques appliqués aux entrées d'adressage, caractérisée en ce que L et/ou respectivement M est strictement compris entre $2^{k-1}$ et $2^k$ (respectivement $2^{m-1}$ et $2^m$), et en ce qu'un décodeur supplémentaire (24) est prévu entre les entrées d'adressage de lignes et/ou respectivement de colonnes et les entrées des portes de décodage de lignes (respectivement de colonnes), ce décodeur étant apte à transmettre aux entrées des portes de décodage de lignes (respectivement de colonnes) des niveaux logiques correspondant :

à la désignation d'une seule ligne (respectivement colonne) correspondante pour chacune de L (respectivement M) adresses données parmi les $2^k$ (respectivement $2^m$) adresses susceptibles d'être reçues par le décodeur supplémentaire ;

à la désignation de deux lignes (respectivement colonnes) correspondantes pour chacune des $2^k - L$ (respectivement $2^m - M$) adresses restantes susceptibles d'être reçues par le décodeur supplémentaire, qui correspondent à des lignes (respectivement colonne) fictives, les mots appliqués aux sorties de la mémoire étant dans ce cas la somme ou le produit logique des mots stockés aux carrefours de chaque colonne (respectivement ligne) désignée et de chaque ligne (respectivement colonne) désignée.

2. Mémoire morte selon la revendication 1, caractérisée par le fait que le décodeur supplémentaire est agencé de telle manière que pour certaines adresses reçues à son entrée il transmette directement et sans modification aux entrées des portes de décodage de lignes (resp. de colonnes), les niveaux logiques et les compléments des chiffres binaires constituant ces adresses, comme si les entrées d'adressage étaient reliées directement et par l'intermédiaire d'inverseurs aux entrées des portes de décodage de lignes (resp. de colonnes) et que pour d'autres adresses il transmette aux entrées des portes de décodage de ligne (resp. de colonne) des niveaux logiques correspondant aux chiffres binaires constituant ces adresses avec une modification telle que deux des entrées communes des portes de décodage de ligne (resp. de colonne) qui devraient recevoir un chiffre et son complément reçoivent en fait toutes deux le même niveau logique.

3. Mémoire morte selon l'une des revendications 1 et 2, caractérisée par le fait qu'outre les k (resp. m) entrées d'adressage de lignes (resp. colonnes), il est prévu une entrée spécifique destinée au décodeur supplémentaire, le niveau logique présent sur cette entrée ayant pour fonction de définir si le décodeur supplémentaire doit autoriser la désignation d'une seule ligne (resp. colonne), laquelle est définie par les autres entrées d'adressage, ou doit autoriser la désignation de deux lignes (resp. colonnes), lesquelles sont définies par les autres entrées d'adressage.

4. Mémoire morte selon la revendication 3, caractérisée par le fait que le décodeur supplémentaire comprend un inverseur commandé inséré en amont d'une entrée commune des portes de décodage de lignes (resp. de colonne), cet inverseur étant commandé par ladite entrée spécifique et recevant une autre entrée, le décodeur supplémentaire étant par ailleurs apte à fournir sur ses sorties les niveaux logiques appliqués aux entrées restantes et leurs compléments.

5. Mémoire morte selon l'une des revendications 1 et 2, caractérisée par le fait que le décodeur supplémentaire comprend k (resp. m) entrées, 2k (resp. m) sorties qui sont reliées aux entrées des portes de décodages de lignes (resp. de colonne) et qui représentent :

soit les k (resp. m) entrées et leurs k (resp. m) compléments pour certaines adresses apparaissant aux entrées du décodeur supplémentaire ;

soit k — 1 (resp. m — 1) entrées et leurs k — 1 (resp. m — 1) compléments et deux niveaux logiques identiques sur les deux sorties restantes du décodeur supplémentaire.

6. Mémoire morte selon l'une des revendications 1 et 2, caractérisée par le fait que le décodeur supplémentaire fournit sur 2k — 6 (resp. 2 m — 6) sorties respectivement le niveau logique et le complément du niveau logique apparaissant sur chacune de k — 3 (resp. m — 3) entrées d'adressage, que sur les six autres sorties apparaissent des combinaisons logiques des trois autres entrées, et que les nombres représentant les adresses de lignes correspondent effectivement à la numérotation des lignes dans l'ordre de celles-ci.

7. Mémoire morte selon l'une des revendications 1 et 2, caractérisée par le fait que le décodeur supplémentaire fournit sur k — 2 sorties les niveaux logiques apparaissant sur k — 2 entrées correspondantes, sur k — 2 autres sorties les compléments de ces niveaux, et sur les quatre sorties restantes des combinaisons logiques très simples des deux entrées restantes.

**Claims**

1. A programmable read-only memory with N storage locations (10), arranged in L lines (12) of M words each comprising P bits (N = L × M × P), comprising k line addressing inputs and m column addressing inputs, the numbers k and m being the binary addressing bit numbers necessary for designating L lines and M columns, L line decoding gates (16), M column decoding gates (18) and P bit outputs adapted to transmit the stored information of the P storage locations at the intersection of a word line and a word column, designated respectively by a line decoding gate and a column decoding gate according to the logic levels applied to the addressing inputs, characterized in that L and/or respectively M is strictly included between $2^{k-1}$ and $2^k$ (respectively $2^{m-1}$ and $2^m$), and that a supplementary decoder (24) is provided between the line addressing inputs and/or respectively the column addressing inputs and the inputs of the line decoding gates (respectively of the column decoding gates), said decoder being adapted to transmit logic levels to the inputs of the line decoding gates (respectively of the column decoding gates), these levels corresponding :

to the designation of a corresponding single line (respectively single column) for each of the L (respectively M) given addresses among the $2^k$ (respectively $2^m$) addresses susceptible of being received by the supplementary decoder ;

to the designation of two lines (respectively columns) corresponding for each of the $2^k$ — L (respectively $2^m$ — M) remaining addresses susceptible of being received by the supplementary decoder, which correspond to fictive lines (respectively columns), the words applied to the outputs of the memory being in this case the logic sum or product of the words stored at the intersections of each designated column (respectively line) and each designated line (respectively column).

2. A read-only memory according to claim 1, characterized in that the supplementary decoder is arranged in such a way that, for certain addresses received at its input, it transmits directly and without modification the logic level and the complements of the binary digits constituting these addresses to the inputs of the line (respectively the column) decoding gates, as if these addressing inputs were directly and via inverters connected to the inputs of the line (respectively the column) decoding gates, and that for other addresses, it transmits logic levels constituting these addresses to the inputs of the line (respectively the column) decoding gates corresponding to the binary digits constituting these addresses, containing however a modification such, that two of the common inputs of the line (respectively the column) decoding gates, which should receive a digit and its complement, receive in fact both the same logic level.

3. A read-only memory according to one of claims 1 and 2, characterized in that in addition to the k (respectively the m) line (respectively column) addressing inputs, there is provided a specific input intented for use by the supplementary decoder, the function of the logic level present at this input being to define, whether the supplementary decoder should authorize the designation of a single line (respectively column), which is defined by the other addressing inputs, or of two lines (respectively columns), which are defined by the other addressing inputs.

4. A read-only memory according to claim 3, characterized in that the supplementary decoder comprises a controlled inverter inserted upstream of a common input of the line (respectively the column) decoding gates, this inverter being controlled by said specific input and receiving another input, the supplementary decoder being further adapted to supply at its outputs the logic levels applied to the remaining inputs and their complements.

5. A read-only memory according to one of claims 1 and 2, characterized in that the supplementary decoder comprises k (respectively m) inputs, 2k (respectively m) outputs which are connected to the inputs of the line (respectively the column) decoding gates, and which represent :

either the k (respectively the m) inputs and their k (respectively their m) complements for certain addresses appearing at the inputs of the supplementary decoder ;

or the k — 1 (respectively the m — 1) complements and two identical logic levels at the two remaining outputs of the supplementary decoder.

6. A read-only memory according to one of claims 1 and 2, characterized in that the supplementary decoder supplies at 2k — 6 (respectively 2m — 6) outputs respectively the logic level and the complement of the logic level appearing at each of k — 3 (respectively the m — 3) addressing inputs, that logic combinations of the three other inputs appear at the six other outputs ; and that the numbers representing the line addresses in fact correspond to the numbering of the lines in their order.

7. A read-only memory according to one of claims 1 and 2, characterized in that the supplementary decoder supplies at k — 2 outputs the logic levels appearing at k — 2 corresponding inputs, at k — 2 further outputs the complements of these levels ; and at the remaining four outputs very simple logic combinations of the two remaining inputs.

**Patentansprüche**

1. Programmierbarer Festspeicher mit N Speicherstellen (10), die in L Zeilen (12) zu M Wörtern mit jeweils P Bits (N = L × M × P) angeordnet sind, mit k Zeilenadressen- und m Spaltenadresseneingängen, wobei die Zahlen k und m der Anzahl der zur Bezeichnung der L Zeilen und M Spalten benötigten Adressenbits entsprechen, mit L Zeilendekodiergattern (16), M Spaltendekodiergattern (18) und P Bitausgängen zur Übertragung der in den P Speicherstellen am Kreuzungspunkt einer Wortzeile und einer Wortspalte gespeicherten Informationen, welche jeweils von einem Zeilendekodiergatter und einem Spaltendekodiergatter gemäß den an die Adressiereingänge angelegten logischen Pegeln bezeichnet sind, dadurch gekennzeichnet, daß die Werte von L und/oder M streng zwischen $2^{k-1}$ und $2^k$ (bzw. $2^{m-1}$ und $2^m$) liegen, und daß ein zusätzlicher Dekoder (24) zwischen den Zeilen- und/oder Spaltenadressiereingängen und den Eingängen der Zeilen- (bzw. der Spalten-) dekodiergatter vorgesehen ist, wobei dieser Dekoder in der Lage ist, an die Eingänge der Zeilen- (bzw. der Spalten-)dekodiergatter logische Pegel anzulegen, die entsprechen :

der Bezeichnung einer einzigen entsprechenden Zeile (bzw. Spalte) für jede der L (bzw. M) gegebenen unter den $2^k$ (bzw. $2^m$) Adressen, die geeignet sind, vom zusätzlichen Dekodierer empfangen werden zu können ;

der Bezeichnung von zwei entsprechenden Zeilen (bzw. Spalten) für jede der $2^k$ — L (bzw. $2^m$ — M) übrigen Adressen, die von dem zusätzlichen Dekoder empfangen werden können und fiktiven Zeilen (bzw. Spalten) entsprechen, wobei in diesem Fall die an den Ausgängen des Speichers anliegenden Wörter die logische Summe oder das logische Produkt der an den Kreuzungspunkten jeder bezeichneten Spalte (bzw. Zeile) und jeder bezeichneten Zeile (bzw. Spalte) ist.

2. Festspeicher nach Anspruch 1, dadurch gekennzeichnet, daß der zusätzliche Dekoder so eingerichtet ist, daß. er für gewisse an seinem Eingang empfangene Adressen direkt und ohne Abänderung die logischen Pegel und die Komplemente der Binärziffern, welche diese Adressen bilden, an die Eingänge der Zeilen- (bzw. Spalten-)dekodiergatter überträgt, so als ob die Adressiereingänge direkt und über Inverter an die Eingänge der Zeilen- (bzw. Spalten-)dekodiergatter angeschlossen wären, und daß er für andere Andressen an die Eingänge der Zeilen- (bzw. Spalten-)dekodiergatter logische Pegel überträgt, welche den diese Adressen bildenden Binärziffern entsprechen, jedoch mit einer solchen Abänderung, daß zwei der gemeinsamen Eingänge der Zeilen- (bzw. Spalten-)dekodiergatter, welcher eine Ziffer und ihr Komplement empfangen müßten, tatsächlich beide den gleichen logischen Pegel empfangen.

3. Festspeicher nach einem der Ansprüche 1 und 2, dadurch gekennzeichnet, daß zusätzlich zu den k (bzw. m) Zeilen- (bzw. Spalten-)adressiereingängen ein spezieller Eingang für den zusätzlichen Dekoder vorgesehen ist, wobei der an diesem Eingang liegende logische Pegel die Aufgabe hat zu bestimmen, ob der zusätzliche Dekoder die Bezeichnung einer einzigen Zeile (bzw. Spalte) zulassen soll, welche von den anderen Adressiereingängen bestimmt wird, oder ob er die Bezeichnung von zwei Zeilen (bzw. Spalten) zulassen soll, welche von den anderen Adressiereingängen bestimmt werden.

4. Festspeicher nach Anspruch 3, dadurch gekennzeichnet, daß der zusätzliche Dekoder einen gesteuerten Inverter vor einem gemeinsamen Eingang der Zeilen- (bzw. Spalten-)dekoder eingefügt enthält, wobei dieser Inverter von dem speziellen Eingang gesteuert wird und einen weiteren Eingang besitzt, und wobei der zusätzliche Dekoder außerdem in der Lage ist, die an die restlichen Eingänge angelegten logischen Pegel und ihre Komplemente an seine Ausgänge zu liefern.

5. Festspeicher nach einem der Ansprüche 1 und 2, dadurch gekennzeichnet, daß der zusätzliche Dekoder k (bzw. m) Eingänge und 2k (bzw. m) Ausgänge besitzt, welche letztere mit den Eingängen der Zeilen- (bzw. Spalten-)dekodiergatter verbunden sind und die :

entweder die k (bzw. m) Eingänge und ihre k (bzw. m) Komplemente für gewisse, an den Eingängen des zusätzlichen Dekoders erscheinende Adressen,

oder k — 1 (bzw. m — 1) Eingänge und ihre k — 1 (bzw. m — 1) Komplemente, und zwei identische logische Pegel an den beiden restlichen Ausgängen des zusätzlichen Dekoders darstellen.

6. Festspeicher nach einem der Ansprüche 1 und 2, dadurch gekennzeichnet, daß der zusätzliche Dekoder an 2k — 6 (bzw. 2m — 6) Ausgänge jeweils den logischen Pegel und das Komplement des an jedem der k — 3 (bzw. m — 3) Adressiereingänge erscheinenden logischen Pegels liefert ; daß an den sechs anderen Ausgängen die logischen Kombinationen der anderen drei Eingänge erscheint, und daß die die Zeilenadressen darstellenden Zahlenwerte tatsächlich der Numerierung der Zeilen in deren Abfolge entsprechen.

7. Festspeicher nach einem der Ansprüche 1 und 2, dadurch gekennzeichnet, daß der zusätzliche Dekoder an k — 2 Ausgängen die an k — 2 entsprechenden Eingängen erscheinenden logischen Pegel, an k — 2 anderen Ausgängen die logischen Komplemente dieser Pegel, und an den verbleibenden vier Ausgänge die sehr einfachen logischen Kombinationen der zwei restlichen Eingänge liefert.

Fig. 1

charge colonne j

décodeur    ligne i
de ligne                                    10

                                            20

décodeur    ligne i+1
de ligne                                    10'

                                            20'

col.    col.
j-1      j

                                            22
                                                    du décodeur
                                                    colonne 18
                        col.
                        j-1     col.
                                 j

                                            sortie
                                            bit h

sortie  bit h-1

## Fig.2

A3  A̅3̅  A2  A̅2̅  A1  A̅1̅  A0  A̅0̅

                                    16
                                            ligne d'adresse 1010

                            NOR

## Fig.3

Fig. 4

k entrées adressage

A3    A2    A1    A0         B

24

Fig.5

OU
excl

28

26

16

16

$\overline{A3}$  A3  $\overline{A2}$  A2  $\overline{A1}$  A1  $\overline{A0}$      A0 ou $\overline{A0}$

A3 A2         A1              A0

ET

ET                    OU

Fig.6

ET    ET              ET

OU

a3  a'3  a2  a'2  a1  a'1              a0  a'0

A3       A2       A1              A0

OU

Fig.7

ET

a'3  a3  a'2  a2  a'1    a1         a'0       a0

4